# FASCICULE DE BREVET EUROPEEN

(11) **EP 2 756 531 B1**
(45) Date de publication et mention de la délivrance du brevet: **24.10.2018**
(21) Numéro de dépôt: 12732691.6
(22) Date de dépôt: 11.06.2012
(51) Int. Cl.: H01L 51/05, H01L 51/00

(54) **TRANSISTOR ORGANIQUE A EFFET DE CHAMP**
ORGANISCHER FELDEFFEKTTRANSISTOR
ORGANIC FIELD-EFFECT TRANSISTOR

(30) Priorité: 14.09.2011 FR 1158178
(43) Date de publication de la demande: 23.07.2014
(73) Titulaire: Commissariat à l'Énergie Atomique et aux Énergies Alternatives, 75015 Paris (FR)
(72) Inventeur: BENWADIH, Mohammed, F-94500 Champagny/marne (FR)
(74) Mandataire: Cabinet Laurent & Charras
(86) Numéro de dépôt international: PCT/FR2012/051301
(87) Numéro de publication internationale: WO 2013/038077

(56) Documents cités:
- WO-A1-2009/105045
- FR-A1- 2 870 989
- JP-A- 5 326 402
- JP-A- 2002 203 861

## Description

### DOMAINE TECHNIQUE

La présente invention à trait au domaine des transistors organiques, comme par exemple les transistors à film mince, plus communément connu sous l'expression anglo-saxonne « *Organic Thin Film Transistor* » (OTFT), et plus particulièrement un transistor organique comprenant des moyens permettant de diminuer la constante diélectrique de la surface du substrat plastique.

### ART ANTERIEUR

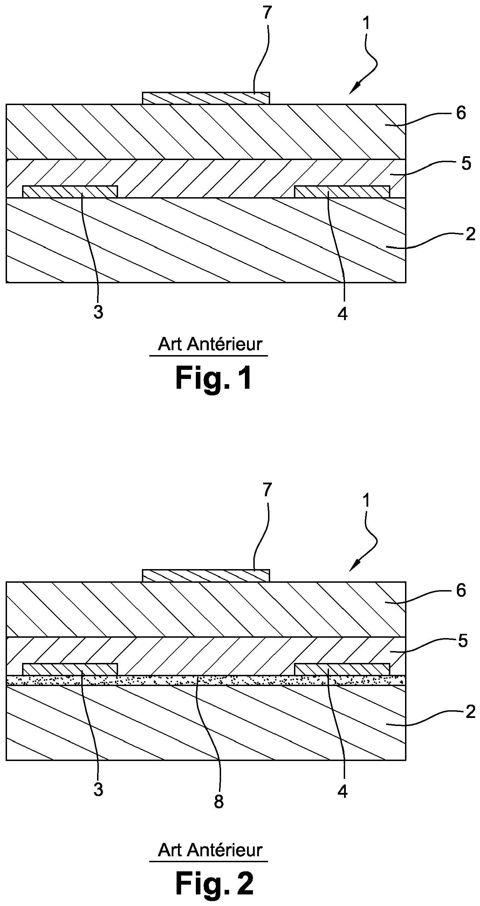

En référence à la figure 1, il est représenté un transistor organique à film mince (OTFT) **1** de l'art antérieur, présentant une structure dite à « grille haute » et à « contacts bas ». Ledit transistor **1** comporte un substrat **2** inférieur, sur la face supérieure duquel sont formés deux électrodes **3**, **4**, respectivement une électrode de source **3** et une électrode de drain **4**. Une couche semi-conductrice **5** est déposée sur le substrat inférieur **2**, et sur les électrodes de source 3 et de drain **4**. Enfin, une couche diélectrique **6** est déposée sur la couche semi-conductrice **5**, et sur laquelle est formée une électrode de grille **7**.

L'effet transistor est obtenu, de manière connue en soi, en appliquant une tension entre l'électrode de grille **7** et le substrat inférieur **2**, de manière à créer, dans la couche semi-conductrice **5**, un canal de conduction **8** entre l'électrode de source **3** et l'électrode de drain **4**.

Toutefois, les performances de ces transistors organiques dépendent fortement des caractéristiques chimiques des interfaces entre la couche semi-conductrice **5**, la couche diélectrique **6** et les électrodes de source **3** et de drain **4**.

En effet, la permittivité électrique des substrats flexibles, formant le substrat inférieur **2**, tel que le polyéthylène naphthalate (PEN), est généralement supérieure à 3 (environ 3,5), générant un stress électrique dans la couche semi-conductrice **5** et/ou en créant un piégeage des charges à l'interface substrat inférieur / couche semi-conductrice (appelé aussi chemin de fuite), ce qui perturbe fortement les performances de ces transistors organiques à « grille haute ».

Les substrats flexibles en polyéthylène naphtalate (PEN) présentent à leur surface une forte concentration de dipôles (groupement acide COOH, polaire OH⁻, fluoré) qui sont électriquement non neutres (charges positives ou négatives) et qui altèrent fortement la conduction électrique dans la couche semi-conductrice **5** de ces transistors organiques. Afin de remédier aux problèmes d'interface et de forte permittivité du substrat inférieur **2**, il est connu de déposer une monocouche auto-assemblée dite SAM selon l'acronyme anglo-saxon « *Self-Assembled Monolayer* » entre le substrat inférieur **2** et la couche semi-conductrice **5** et les électrodes de source **3** et de drain **4**, et ce, pour limiter l'influence du substrat **2**.

Une telle structure de transistor organique à effet de champ est notamment décrite dans la publication « Influence of Substrate Surface Chemistry on the Performance of Top-Gate Organic Thin-Film Transistors » ; Boudinet D, Benwadih M, Altazin S, Verilhac JM, De Vito E, Serbutoviez C, Horowitz G, Facchetti A ; J Am CHEM SOC, 2011 Jul 6 ; 133 « 26 » ; 9968-9971, EPUB 2011 Jun 10., PMID ; 21661723 [pubmed].

En référence à la figure 2, décrivant également un transistor à effet de champ de l'art antérieur, on retrouve la structure du transistor de la figure 1, mais celui-ci comporte en outre une monocouche auto-assemblée **8** positionnée entre le substrat inférieur **2** et la couche semi-conductrice **5** et les électrodes de source **3** et de drain **4**.

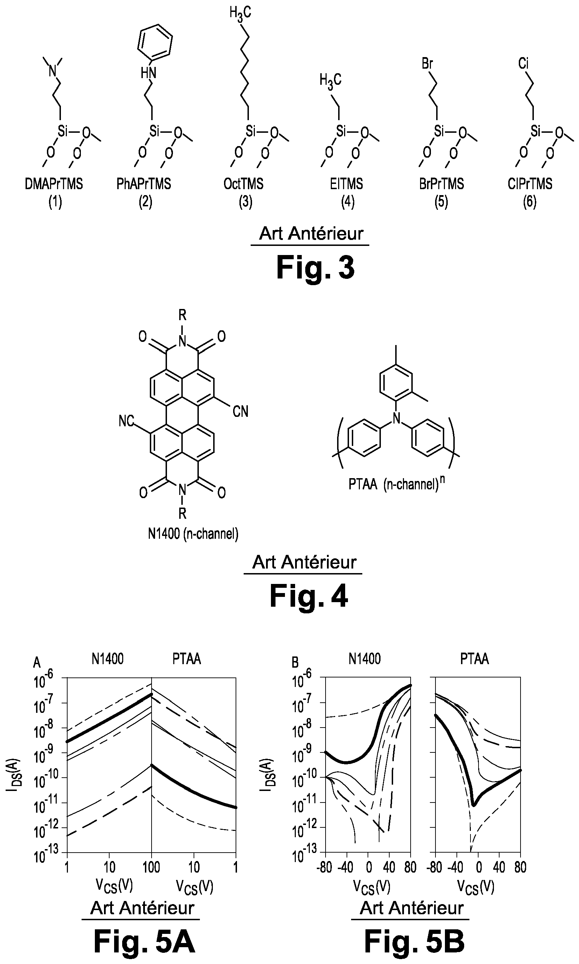

Plusieurs essais ont été réalisés avec une couche semi-conductrice **5**, en référence à la figure 4, réalisée en un dérivé de *N*,*N'*-dialkylsubstituted-(1,7&1,6)-dicyanoperylene-3,4:9,10-bis(dicarboximide) (n-channel), commercialisé sous la marque ActivInk N1400 par la société POLYERA, ou en poly[bis(4-phenyl)(2,4,6-trimethylphenyl)amine] dit poly(triaryl amine) ou PTAA (P-channel) et plusieurs monocouches auto-assemblées (SAM), en référence à la figure 3, comportant des groupements fonctionnels alkyl / phenyl-amino (exemples 1 et 2), alkyl (exemples 3 et 4) et halo-alkyl (exemples 5 et 6).

Comme on peut le voir sur les figures 5A et 5B, les performances électriques de ces transistors organiques se dégradent ou se déplacent quelle que soit la nature de la couche semi-conductrice **5** et/ou la nature de la monocouche auto-assemblée (SAM) **8**.

Les documents suivants on été cités dans le rapport de recherche. Le document WO2009105045 A divulgue un OFET sur un substrat poreux pour rendre plus facile l'impression d'encre. Les documents FR 2 870 989 et JP 5 326402 divulguent un substrat pour application électronique comprenant un support flexible recouvert successivement d'une couche poreuse et d'une couche de silicium polycristallin. Le document JP 2002 203861 divulgue un TFT sur une couche poreuse sur un substrat plastique. La couche poreuse sert de germe de croissance de la couche active en silicium polycristallin.

### EXPOSE DE L'INVENTION

L'un des buts de l'invention est donc de remédier à ces inconvénients en proposant un transistor organique à effet de champ du type OTFT de conception simple, peu onéreuse et limitant la dégradation des performances de ces transistors organiques.

A cet effet, et conformément à l'invention, il est proposé un transistor organique comprenant au moins un substrat inférieur en matière plastique dit substrat plastique, deux électrodes, respectivement une électrode de source et une électrode de drain, déposées au dessus du substrat plastique, une couche semi-conductrice réalisée en un matériau semi-conducteur organique et déposée sur et en contact avec les électrodes et le substrat plastique, une couche diélectrique réalisée en un matériau diélectrique et déposée sur la couche semi-conductrice, et une électrode de grille formée sur la couche diélectrique.

Cet transistor organique comporte en outre, une couche réalisée en un matériau poreux et diélectrique, s'étendant entre le substrat plastique et la couche semi-conductrice, ladite couche poreuse s'étendant au moins à l'aplomb du canal de conduction, c'est-à-dire entre les électrodes de source et de drain, afin de diminuer la constante diélectrique de la surface dudit substrat plastique.

Le dépôt de cette couche poreuse entre le substrat inférieur et la couche semi-conductrice et les électrodes de source et de drain permet de réduire significativement la permittivité, c'est-à-dire la constante diélectrique entre le substrat plastique et la couche semi-conductrice, ce qui permet d'une part d'éviter l'apparition d'un stress électrique et d'autre part, de maintenir de bonnes performances du transistor organique.

De préférence, les pores de la couche poreuse présentent des dimensions inférieures à 50 nanomètres en diamètre.

Les groupements terminaux de la couche poreuse sont avantageusement apolaires et la couche semi-conductrice présente une faible rugosité.

De préférence, la couche poreuse présente une permittivité inférieure à 2,5.

Par ailleurs, la couche poreuse est obtenue à partir de monomère d'acrylate et/ou au moins l'un de ses dérivés, à partir du polystyrène, du polyvinylphénol ou de leurs mélanges.

Elle peut être obtenue par photo réticulation de méthacrylate de méthyle à travers un masque de photolithogravure.

Elle peut également être obtenue à partir de silane, ou être constituée de silice poreuse.

Elle peut encore être constituée d'alumine poreuse obtenue par un procédé sol-gel.

### DESCRIPTION SOMMAIRE DES FIGURES

D'autres avantages et caractéristiques ressortiront mieux de la description qui va suivre, de plusieurs variantes d'exécution du transistor organique à effet de champ conforme à l'invention, données à titre d'exemple non limitatif en référence aux dessins annexés pour lesquels :
- la figure 1 est une vue en coupe schématique d'un transistor organique à « grille haute » et « contact bas » du type OTFT de l'art antérieur,
- la figure 2 est une vue en coupe schématique d'un transistor organique à « grille haute » et « contacts bas » du type OTFT comportant une monocouche auto-assemblée (SAM) de l'art antérieur,
- la figure 3 est une représentation schématique des molécules à partir desquelles la monocouche auto assemblée (SAM) des transistors organique de l'art antérieur est obtenue,
- la figure 4 est une représentation schématique des différentes molécules à partir desquelles est obtenue la couche semi-conductrice des transistors organiques de l'art antérieur,
- les figures 5A et 5B sont des courbes représentant l'intensité du courant entre le drain et la source en fonction d'une part de la tension entre le drain et la source, et d'autre part de la tension entre la grille et la source des transistors organiques à effet de champ de l'art antérieur,
- la figure 6 est une vue en coupe schématique d'un transistor organique à effet de champ du type OTFT suivant l'invention,
- la figure 7 est une courbe représentant l'intensité du courant mesurée entre le drain et la source en fonction de la tension entre la grille et la source, d'une part pour un transistor organique à effet de champ comportant une couche poreuse conformément à l'invention, et d'autre part pour un transistor organique à effet de champ de l'art antérieur ne comportant pas de couche poreuse.

### DESCRIPTION DETAILLEE DE L'INVENTION

Par souci de clarté, dans la suite de l'invention, les mêmes éléments ont été désignés par les mêmes références au sein des différentes figures. De plus, les diverses vues en coupe ne sont pas nécessairement tracées à l'échelle.

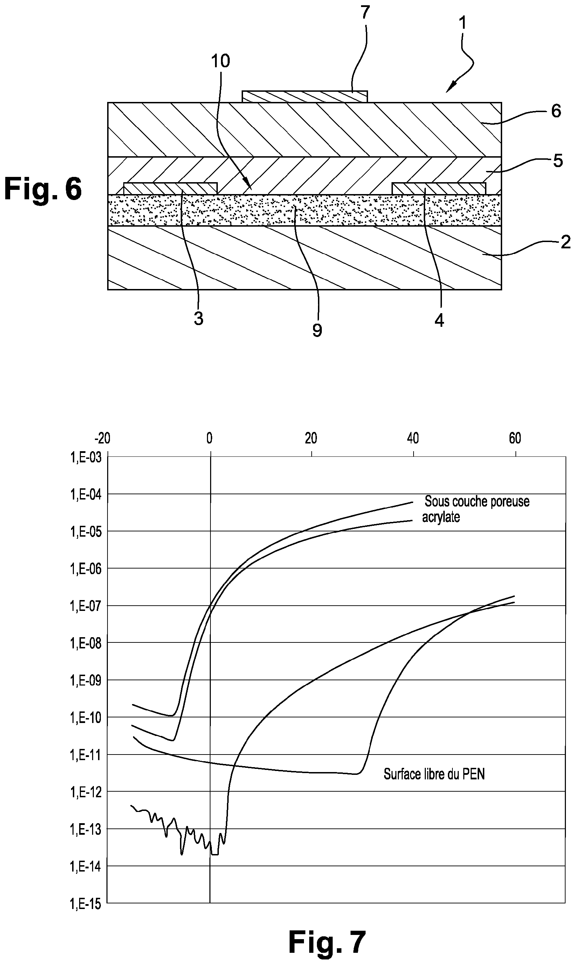

En référence à la figure 6, le transistor du type OTFT **1** selon l'invention, comporte un substrat inférieur en matière plastique dit substrat plastique **2**, sur la face supérieure duquel est déposée une couche poreuse **9** réalisée en un matériau poreux.

Ledit substrat plastique 2 est réalisé en un matériau plastique choisi dans la liste suivante : les polymères tels que polyéthylène téréphtalate (PET), polyéthylène naphtalate (PEN), polyimide (PI), etc... ou tout autre matériau plastique bien connu de l'homme du métier.

La couche poreuse **9** est réalisée en un matériau diélectrique présentant une permittivité inférieure à 2.5, une structure chimique stable et comportant des groupements neutres sans dipôles polaires, c'est-à-dire apolaires. Ainsi ladite couche poreuse **9** est électriquement neutre, dans la mesure où elle ne comporte pas de groupements électrodonneurs ou électropositifs.

De plus, les pores de la couche poreuse **9** présentent de préférence un diamètre inférieur à 50 nanomètres. L'important est d'obtenir une surface finale ou terminale de la couche semi-conductrice de faible rugosité (Ra ≤ 15 nanomètres). La taille des pores est donc choisie en fonction de l'épaisseur de la couche semi-conductrice : en effet, il est bien connu que plus la couche est épaisse, et moins sa surface terminale reflète la rugosité de son support initial.

Par exemple, pour une épaisseur de la couche semi-conductrice de 140 nm, on accepte un diamètre des pores inférieur ou égal à 50 nanomètres.

De même, pour une épaisseur de la couche semi-conductrice de 80 nm, on accepte un diamètre des pores inférieur ou égal à 20 nanomètres.

Enfin, pour une épaisseur de la couche semi-conductrice de 50 nm, on accepte un diamètre des pores inférieur ou égal à 10 nanomètres.

De préférence, la couche poreuse **9** est obtenue à partir de monomère d'acrylate et/ou au moins l'un de ses dérivés, et de préférence par photo réticulation de méthacrylate de méthyle à travers un masque de photolithogravure et/ou à partir de silane et/ou de silice poreuse et/ou d'alumine poreuse obtenue par un procédé sol-gel et/ou tout autre matériau approprié connu de l'homme du métier. D'autres procédés comme l'émulsion, le démixage ou le dépôt direct à travers un masque peuvent également être mis en oeuvre.

La couche poreuse **9** peut être déposée sur le substrat plastique **2** par tout procédé bien connu de l'homme du métier, tel qu'un dépôt à la tournette (mieux connu sous l'expression anglo-saxonne « *spin coating* »), un dépôt par étalement, un dépôt par sérigraphie ou un dépôt par impression par exemple, voire par héliogravure, flexogravure ou encore par jet d'encre.

Le transistor comporte par ailleurs deux électrodes **3**, **4**, une électrode de source **3** et une électrode de drain **4**, déposées sur la couche poreuse **9**. Une couche semi-conductrice **5** est déposée sur la couche poreuse **9,** l'électrode de source **3** et l'électrode de drain **4.** Une couche diélectrique **6** est déposée sur la couche semi-conductrice **5**. Et une électrode de grille **7** est déposée sur ladite couche diélectrique **6**.

Les électrodes de source **3** et de drain **4** sont, par exemple, réalisées en métal, tel que l'aluminium, le titane, le nickel, l'or, le chrome, etc..., ou en particules métalliques, en oxydes métalliques, tels que l'oxyde d'indium-étain, l'oxyde d'indium-zinc, etc..., voire même en polymères conducteurs, tels que le 3, 4 - polyéthylène dioxythiophène-polystyrène, sulfonate (PEDOT : PSS) ou polyaniline, etc..., les matériaux en silicium dopé ou dans tout autre matériau conducteur approprié bien connu de l'homme du métier.

La couche semi-conductrice **5** est, par exemple, constituée d'une couche organique semi-conductrice réalisée en un matériau choisi dans la liste suivante : molécules organiques semi-conductrices telles que tetracene, pentancene, phtalocyanine, polymères semiconducteurs tels que polytiophène, polyfluorène, polyphenylene vinylene ou leurs dérivés tels que poly (3-octyl), thiophene, poly [2-methoxy-5-(2'-ethyl-hexyloxy)-1,4-], phenylene, vinylene ou oligomère tel que α-sexithiophènes.

Toutefois, la couche semi-conductrice **5** peut également être réalisée en un matériau inorganique semi-conducteur, tel que le silicium ou l'arséniure de gallium (GaAs) ou encore le ZnO par exemple, sans pour autant sortir du cadre de l'invention.

La couche diélectrique **6** est, quant à elle, réalisée en un matériau choisi par exemple dans la liste suivante : dioxyde de silicium, nitrate de silicium, dioxyde de titane, oxyde d'aluminium, dioxyde d'hafnium, les polyimides, polyvinyle, pyrrolidone, polyméthylméthacrylate, polyamide, parylène, polystyrène ou les fluoropolymères ou dans tout autre matériau diélectrique bien connu de l'homme du métier.

Le dépôt de la couche poreuse **9** entre le substrat inférieur **2** et la couche semi-conductrice **5** et les électrodes de source **3** et de drain **4** permet de réduire significativement la permittivité, c'est-à-dire la constante diélectrique entre le substrat plastique **2** et la couche semi-conductrice **5**. Ce faisant, on évite l'apparition d'un stress électrique et d'un piégeage des charges et on maintient de bonnes performances du transistor organique.

Par exemple, le dépôt d'une couche poreuse **9** en méthacrylate de méthyle déposée par photo réticulation à travers un masque sur une couche plastique **2** en polyéthylène naphtalate (PEN) permet de diminuer la permittivité du polyéthylène naphtalate (PEN) qui est normalement de 3 à 1.5.

On notera que, dans cet exemple particulier de réalisation, la couche poreuse **9** est déposée pleine plaque sur le substrat plastique **2**, c'est-à-dire qu'elle recouvre l'intégralité de la face supérieure dudit substrat plastique **2**. Toutefois, la couche poreuse peut n'être déposée qu'à l'aplomb du canal de conduction **10** de la couche semi-conductrice **5** s'étendant entre les électrodes de source **3** et de drain **4**, sans sortir du cadre de l'invention.

Comme on peut le voir sur la figure 7, qui est une courbe représentant l'intensité du courant mesurée entre le drain et la source en fonction de la tension entre la grille et la source d'une part pour un transistor organique à effet de champ comportant une couche poreuse **9** conformément à l'invention, et d'autre part pour un transistor organique à effet de champ de l'art antérieur ne comportant pas de couche poreuse **9**, ladite couche poreuse du transistor selon l'invention permet de préserver les performances dudit transistor contrairement aux transistors de l'art antérieur. En effet, dans les transistors à effet de champ de l'art antérieur, la surface du substrat plastique **2** en polyéthylène naphtalate (PEN) attire les électrons et les différents types de dipôle présents sur la surface du substrat plastique **2** décalent fortement les courbes de transistor dans les deux régimes, à savoir le régime linéaire et le régime saturé, contrairement au transistor selon l'invention pour lequel les courbes des deux régimes ne sont ni décalés ni dégradés.

## Revendications

1. Transistor organique (1) comprenant au moins un substrat inférieur en matière plastique dit substrat plastique (2), deux électrodes (3, 4), respectivement une électrode de source (3) et une électrode de drain (4), déposées au dessus du substrat plastique (2), une couche semi-conductrice (5) réalisée en un matériau semi-conducteur organique et déposée sur et en contact avec les électrodes (3, 4) et au dessus du substrat plastique (2), une couche diélectrique (6) réalisée en un matériau diélectrique déposée sur la couche semi-conductrice (5), et une électrode de grille (7) formée sur ladite couche diélectrique (6), ***caractérisé* en ce qu'**il comporte en outre une couche poreuse (9) réalisée en un matériau diélectrique, et s'étendant entre le substrat plastique (2) et la couche semi-conductrice (5), ladite couche poreuse (9) s'étendant au moins à l'aplomb entre les électrodes de source (3) et de drain (4), afin de diminuer la constante diélectrique de la surface du substrat plastique (2).

2. Transistor organique selon la revendication 1, ***caractérisé* en ce que** les pores de la couche poreuse (9) présentent un diamètre inférieur à 50 nanomètres.

3. Transistor organique selon l'une des revendications 1 et 2, ***caractérisé* en ce que** la couche semi-conductrice (5) présente une rugosité inférieure ou égale à 15 nanomètres.

4. Transistor organique selon l'une des revendications 1 à 3, ***caractérisé* en ce que** les groupements terminaux de la couche poreuse (9) sont apolaires.

5. Transistor organique selon l'une quelconque des revendications 1 à 4, ***caractérisé* en ce que** la couche poreuse (9) présente une permittivité inférieure à 2,5.

6. Transistor organique selon l'une quelconque des revendications 1 à 5, ***caractérisé* en ce que** la couche poreuse (9) est obtenue à partir de monomère d'acrylate et/ou au moins l'un de ses dérivés, ou à partir du polystyrène, du polyvinylphénol ou de leurs mélanges.

7. Transistor organique selon la revendication 6, ***caractérisé* en ce que** la couche poreuse (9) est obtenue par photoréticulation de méthacrylate de méthyle à travers un masque.

8. Transistor organique selon l'une quelconque des revendications 1 à 5, ***caractérisé* en ce que** la couche poreuse (9) est obtenue à partir de silane.

9. Transistor organique selon l'une quelconque des revendications 1 à 5, ***caractérisé* en ce que** la couche poreuse (9) est constituée de silice poreuse.

10. Transistor organique selon l'une quelconque des revendications 1 à 5, ***caractérisé* en ce que** la couche poreuse (9) est constituée d'alumine poreuse obtenue par un procédé sol-gel.

## Patentansprüche

1. Organischer Transistor (1) mit mindestens einem unteren Substrat aus Kunststoffmaterial, das sogenannte Kunststoffsubstrat (2), zwei Elektroden (3, 4), jeweils einer Source-Elektrode (3) und einer Drain-Elektrode (4), abgeschieden über dem Kunststoffsubstrat (2), einer Halbleiterschicht (5) aus einem organischen Halbleitermaterial und abgeschieden auf den Elektroden (3, 4) und in Kontakt mit ihnen und über dem Kunststoffsubstrat (2), einer dielektrischen Schicht (6), bestehend aus einem dielektrischen Material, die auf der Halbleiterschicht (5) abgeschieden ist, und eine Gate-Elektrode (7), die auf der dielektrischen Schicht (6) ausgebildet ist, **dadurch gekennzeichnet, dass** sie ferner eine poröse Schicht (9) umfasst, bestehend aus einem dielektrischen Material, die sich zwischen dem Kunststoffsubstrat (2) und dieser Halbleiterschicht (5) erstreckt, wobei sich diese poröse Schicht (9) mindestens teilweise senkrecht zwischen der Source- (3) und der Drain- (4) Elektrode erstreckt, um die Dielektrizitätskonstante der Oberfläche des Kunststoffsubstrats (2) zu verringern.

2. Organischer Transistor nach Anspruch 1, **dadurch gekennzeichnet, dass** die Poren der porösen Schicht (9) einen Durchmesser von weniger als 50 Nanometern aufweisen.

3. Organischer Transistor nach einem der Ansprüche 1 und 2, **dadurch gekennzeichnet, dass** die Halbleiterschicht (5) eine Rauheit von kleiner oder gleich 15 Nanometer aufweist.

4. Organischer Transistor nach einem der Ansprüche 1 bis 3, **dadurch gekennzeichnet, dass** die terminalen Gruppen der porösen Schicht (9) apolar sind.

5. Organischer Transistor nach einem der Ansprüche 1 bis 4, **dadurch gekennzeichnet, dass** die poröse Schicht (9) eine Permittivität von unter 2,5 hat.

6. Organischer Transistor nach einem der Ansprüche 1 bis 5, **dadurch gekennzeichnet, dass** die poröse Schicht (9) aus einem Acrylatmonomer und/ oder mindestens einem seiner Derivate, oder aus Polystyrol, Polyvinylphenol oder Mischungen daraus, besteht.

7. Organischer Transistor nach Anspruch 6, **dadurch gekennzeichnet, dass** die poröse Schicht (9) durch Fotovernetzung von Methylmethacrylat durch eine Maske erzeugt wird.

8. Organischer Transistor nach einem der Ansprüche 1 bis 5, **dadurch gekennzeichnet, dass** die poröse Schicht (9) aus Silan hergestellt wird.

9. Organischer Transistor nach einem der Ansprüche 1 bis 5, **dadurch gekennzeichnet, dass** die poröse Schicht (9) aus porösem Siliziumoxid besteht.

10. Organischer Transistor nach einem der Ansprüche 1 bis 5, **dadurch gekennzeichnet, dass** die poröse Schicht (9) aus porösem Aluminiumoxid besteht, das durch einen Sol-Gel-Prozess erhalten wird.

## Claims

1. An organic transistor (1) comprising at least one lower substrate made of plastic material, called plastic substrate (2), two electrodes (3, 4), respectively a source electrode (3) and a drain electrode (4), deposited above the plastic substrate (2), a semiconductor layer (5) made of an organic semiconductor material and deposited on top of and in contact with the electrodes (3, 4) and above the plastic substrate (2), a dielectric layer (6) made of a dielectric material and deposited on the semiconductor layer (5), and a gate electrode (7) formed on said dielectric layer (6), wherein it further comprises a porous layer (9) made of a dielectric material, and extending between the plastic substrate (2) and the semiconductor layer (5), said porous layer (9) extending at least under the area between the source (3) and drain (4) electrodes, to decrease the dielectric constant of the surface of said plastic substrate (2).

2. The organic transistor of claim 1, wherein the pores of the porous layer (9) have a diameter smaller than 50 nanometers.

3. The organic transistor of any of claims 1 and 2, wherein the semiconductor layer (5) has a roughness smaller than or equal to 15 nanometers.

4. The organic transistor of any of claims 1 to 3, wherein the end groups of the porous layer (9) are non-polar.

5. The organic transistor of any of claims 1 to 4, wherein the porous layer (9) has a permittivity lower than 2.5.

6. The organic transistor of any of claims 1 to 5, wherein the porous layer (9) is obtained from acrylate monomer and/or at least one derivative thereof, or from polystyrene, from polyvinylphenol, or from mixtures thereof.

7. The organic transistor of claim 6, wherein the porous layer (9) is obtained by photocrosslinking of methyl methacrylate through a mask.

8. The organic transistor of any of claims 1 to 5, wherein the porous layer (9) is obtained from silane.

9. The organic transistor of any of claims 1 to 5, wherein the porous layer (9) is made of porous silica.

10. The organic transistor of any of claims 1 to 5, wherein the porous layer (9) is made of porous alumina obtained by a sol-gel method.
